# EUROPEAN PATENT APPLICATION

(11) **EP 3 944 346 A1**
(43) Date of publication of application: **26.01.2022**
(21) Application number: 21181126.0
(22) Date of filing: 23.06.2021
(51) Int. Cl.: H01L 33/58, H01L 25/075, H01L 33/60

(54) **METHOD OF MANUFACTURING A LIGHT EMITTING DEVICE**

(30) Priority: 22.07.2020 CN 202010710107
(71) Applicant: InnoLux Corporation, Chu-Nan, Miao-Li 350 (TW)
(72) Inventor: YUEH, Jui-Jen, 350 Miao-Li County (TW)
(74) Representative: Straus, Alexander

(57) **Abstract**

A method of manufacturing a light emitting device (100) is provided, the method at least includes the following steps: a substrate (10) is provided, a light emitting unit (14) is bonded on the substrate (14), an insulating layer (16) is formed on the substrate (10) so that at least a part of the light emitting unit (14) is enclosed by the insulating layer (16), and a collimator (18) corresponding to the light emitting unit (14) is formed on the substrate (10) after the insulating layer (16) is formed.

## Description

### Field of the Disclosure

The present disclosure relates to a manufacturing method of a light emitting device, in particular to a manufacturing method combining a light emitting unit and a collimator in a light emitting device.

### Background of the Disclosure

Light-emitting devices can be used as necessary components of displays, and are widely used in electronic products, such as mobile phones, tablet computers, automotive displays and so on. Sometimes, the display needs anti-peeping function, so that the user can watch the screen of the display from a specific angle, when it is applied to personal electronic products (such as mobile phones or tablet computers), it can improve privacy. When the anti-peeping function is applied to the vehicle display device, such as the display installed in the front passenger seat, it can also avoid disturbing the driving sight and meet the safety requirements. To achieve the anti-peeping function, the collimator can also be combined with the light emitting device of the display device, the collimator can converge or reflect the divergent light into parallel light, to make the display screen has the anti-peeping function.

### Summary of the Disclosure

This in mind, the present disclosure aims at providing a manufacturing method combining a light emitting unit and a collimator in a light emitting device.

This is achieved by a method according to the claims. The dependent claims pertain to corresponding further developments and improvements.

As will be seen more clearly from the detailed description following below, a method for manufacturing a light emitting device is provided by the present disclosure. The method includes the following steps: firstly, providing a substrate, then bonding a light emitting unit on the substrate, then forming an insulating layer on the substrate so that at least a part of the light emitting unit is enclosed by the insulating layer, and forming a collimator corresponding to the light emitting unit on the substrate after the insulating layer is formed.

The present disclosure is characterized by providing a method for directly combining a light emitting unit with a collimator in the process of manufacturing a light emitting device. In this way, the light emitting device in the subsequent display device itself has a collimator, so that the user can see the displayed screen only when viewing the display device from a specific angle, that is to say, the display device itself has an anti-peeping function. In the traditional technology, sticking the peep-proof film on the surface of the finished display device may have some problems, such as uneven adhesion, thick thickness, poor light transmittance and so on. According to the present disclosure, the above problems can be overcome, and a display device with higher quality and peep prevention function can be manufactured.

### Brief Description of the Drawings

In the following, the disclosure is further illustrated by way of example, taking reference to the accompanying drawings. Thereof:
Fig. 1 to Fig. 4 show cross-sectional structural diagrams of the manufacturing process of the light emitting unit according to the first embodiment of the present disclosure;
Fig. 5 shows a schematic cross-sectional structure of a light emitting unit according to a second embodiment of the present disclosure;
Fig. 6 shows a schematic cross-sectional structure of a light emitting unit according to a third embodiment of the present disclosure;
Fig. 7 shows a schematic cross-sectional structure of a light emitting unit according to a fourth embodiment of the present disclosure;
Fig. 8 shows a schematic cross-sectional structure of a light emitting unit according to a fifth embodiment of the present disclosure;
Fig. 9 shows a schematic cross-sectional structure of a light emitting unit according to a sixth embodiment of the present disclosure; and
Fig. 10 shows a schematic cross-sectional structure of a light emitting unit according to a seventh embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of an electronic device (i.e. a display device in this disclosure), and certain elements in various drawings may not be drawn to scale. In addition, the number and dimension of each device shown in drawings are only illustrative and are not intended to limit the scope of the present disclosure.

Certain terms are used throughout the description and following claims to refer to particular components. As one skilled in the art will understand, electronic equipment manufacturers may refer to a component by different names. This document does not intend to distinguish between components that differ in name but not function. In the following description and in the claims, the terms "include", "comprise" and "have" are used in an open-ended fashion, and thus should be interpreted to mean "include, but not limited to...". Thus, when the terms "include", "comprise" and/or "have" are used in the description of the present disclosure, the corresponding features, areas, steps, operations and/or components would be pointed to existence, but not limited to the existence of one or a plurality of the corresponding features, areas, steps, operations and/or components.

It will be understood that when an element or layer is referred to as being "(electrically) connected to" another element or layer, it can be directly (electrically) connected to the other element or layer, or intervening elements or layers may be presented. In contrast, when an element is referred to as being "directly (electrically) connected to" another element or layer, there are no intervening elements or layers presented. In contrast, when an element is referred to as being "disposed on" or "formed on" A element, it may be directly disposed on (or formed on) A element, or may be indirectly disposed on (or formed on) A element through other component. In contrast, when an element is referred to as being" disposed between" A element and B element, it may be directly disposed between A element and B element, or may be indirectly disposed between A element and B element through other component.

The terms "about", "substantially", "equal", or "same" generally mean within 20% of a given value or range, or mean within 10%, 5%, 3%, 2%, 1%, or 0.5% of a given value or range.

In addition, the phrase "in a range from a first value to a second value" indicates the range includes the first value, the second value, and other values in between.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

It should be noted that the technical features in different embodiments described in the following can be replaced, recombined, or mixed with one another to constitute another embodiment without departing from the spirit of the present disclosure.

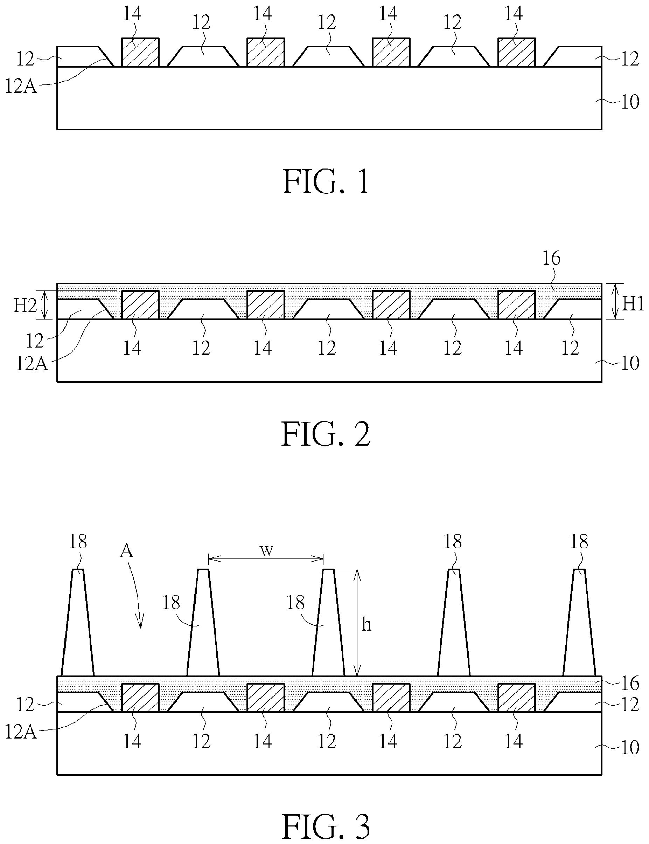

Please refer to Fig. 1 to Fig. 4, which are schematic structural diagrams showing the manufacturing process of the light emitting unit according to the first embodiment of the present disclosure. First, as shown in Fig. 1, a substrate 10 is provided, which may include a substrate, a buffer layer and a circuit layer on the substrate, the substrate material may include glass, polyimide (PI), polycarbonate (PC), polyethylene naphthalate (PEN), triacetate (TAC), polyethylene terephthalate (PET) or a combination thereof, but not limited thereto. In this embodiment, for example, the buffer layer and the circuit layer can be simultaneously disposed on the substrate, and the circuit layer can also be directly disposed on the substrate. The material of the buffer layer can include inorganic materials such as silicon nitride layer and silicon oxide layer; The circuit layer is disposed on the substrate, for example, a driving circuit, the driving circuit may include gate lines, signal lines, thin film transistors, etc.

Then, at least one light emitting unit 14 is bonded on the substrate 10. For example, a pixel definition layer (PDL)12 having at least one opening 12A may be formed on the substrate 10, and the light emitting unit 14 may be located in the opening 12A of the pixel definition layer 12. The bonding of the light-emitting elements 14 may be eutectic bonding, flip chip bonding, surface mount technology, or conductive adhesive bonding (ACF). In Fig. 2, the pixel definition layer 12 has a plurality of openings 12A, and a plurality of light emitting units 14 bonded on the substrate 10 are respectively located in one opening 12A as an example, the openings 12 can also be exemplified as grooves. The light emitting unit 14 is, for example, a light emitting diode (LED), which may include an organic light emitting diode or an inorganic light emitting diode (such as a quantum dot LED, a mini LED, a micro LED or a nano LED), and the type of the light emitting diode may be vertical or flip-chip, however, the present disclosure is not limited thereto. The pixel defining layer 12 may comprise suitable insulating materials, such as silicon oxide, silicon nitride, silicon oxynitride, organic insulating layer or any other suitable insulating materials or combinations thereof, but is not limited thereto.

The light emitting unit 14 described in this disclosure can be combined with other components (such as control circuit, etc.) to make a self-luminous display device, and the pixel definition layer 12 is used to define the position of each pixel on the display device. In this embodiment, the material of the pixel definition layer 12 may include transparent photoresist, gray photoresist, white photoresist or black photoresist, but the present disclosure is not limited to this. These technologies belong to the conventional technologies in the field, and will not be described in detail here.

Then, as shown in Fig. 2, an insulating layer 16 is formed on the substrate 10, so that the light emitting unit 14 is enclosed or coated by the insulating layer 16. The material of the insulating layer 16 can include transparent material or translucent material, such as PMMA, polycarbonate, silicone resin, epoxy resin or the combination thereof, and the insulating layer 16 can also be a single layer structure or a composite layer structure (not shown in the figure), but the disclosure is not limited to this. In addition, "the light emitting unit 14 is enclosed by the insulating layer 16", which may mean that the light emitting unit 14 is completely covered by the insulating layer 16, or the light emitting unit 14 is partially surrounded by the insulating layer 16 (for example, the insulating layer 16 surrounds the lower part or the side of the light emitting unit 14). In another embodiment, if the thickness H1 of the insulating layer 16 is smaller than the thickness H2 of the light emitting unit 14, it means that part of the light emitting unit 14 is enclosed by the insulating layer 16. If the thickness H1 of the insulating layer 16 is larger than the thickness H2 of the light emitting units 14, it means that all the light emitting units 14 are enclosed by the insulating layer 16. If the light emitting unit 14 is an organic light emitting diode, the thickness H2 includes an anode layer, an organic light-emitting layer and a cathode layer. If it is an inorganic light emitting diode, its thickness H2 may include an electrode, a P-type semiconductor layer, an N-type semiconductor layer and a quantum well light-emitting layer. In other words, if the light emitting unit 14 is partially enclosed by the insulating layer 16, the electrodes of the light emitting unit 14 or the P-type semiconductor layer or the N-type semiconductor layer may be exposed and part of the inorganic light emitting diodes may be covered by the insulating layer 16. If an insulating layer 16 is provided or included around the light emitting unit 14, it should met the definition of "enclosed" described in this disclosure.

In this disclosure, forming the insulating layer 16 on or around the light emitting unit 14 has the following advantages, such as protecting the light emitting unit 14, fixing the position of the light emitting unit 14 to keep the structure stable, or forming a relatively flat surface on the light emitting unit 14 to facilitate the subsequent formation of other elements (such as collimators).

Next, as shown in Fig. 3, a plurality of collimators 18 are formed on the surface of the insulating layer 16, the collimators 18 are made of metal (such as aluminum, silver, titanium or alloys thereof); non-transparent resins, such as photoresists of different colors (such as black, white, gray) or inks of different colors; transparent resins, such as a material with a refractive index between 1.5 and 2.0, such as PMMA, polycarbonate, silicone resin, epoxy resin or the combination thereof, but the present disclosure is not limited to this. In some embodiments of the present disclosure, the collimator 18 can form a cavity A with light collection efficiency corresponding to the light emitting unit 14. In addition, in another embodiment, the cavity A can be filled with materials that can concentrate light patterns, increase color purity, increase brightness, or not fill with any materials according to product requirements, that is to say, the collimator 18 is positioned corresponding to each light emitting unit 14. More specifically, from the sectional view, the light emitting unit 14 in the present disclosure is preferably disposed between two adjacent collimators 18, or the collimators 18 can be aligned with the pixel defining layer 12 in the vertical direction (for example, aligned with the top edge of the opening 12A of the pixel defining layer 12). In some embodiments of this disclosure, when viewed from a top view (not shown), the collimator 18 may be a plurality of parallel strip structures, and the light emitting units 14 are arranged between adjacent strip structures, or in other embodiments, when viewed from a top view (not shown), the collimator 18 may be a lattice structure, and the light emitting units 14 are arranged in the lattice structure. In this disclosure, the divergent light emitted from the light emitting unit 14 is converged into parallel light traveling almost along the vertical direction by the reflection of the collimator 18, so that the peep prevention effects can be achieved by the different shapes of the collimator 18. For example, the measured light of the condensed light reflected by the collimator 18 is more concentrated than the measured light of the light emitted by the light emitting unit 140.

In this embodiment, the horizontal distance between the surfaces of two adjacent collimators 18 is defined as a distance w, and the vertical height of any collimator 18 is defined as a height h, where the height h is the vertical distance between the surface of the insulating layer 16 and the top surface of the collimator 18. In some embodiments, the distance w and the height h can satisfy the condition of h>(w/2), but the present disclosure is not limited thereto.

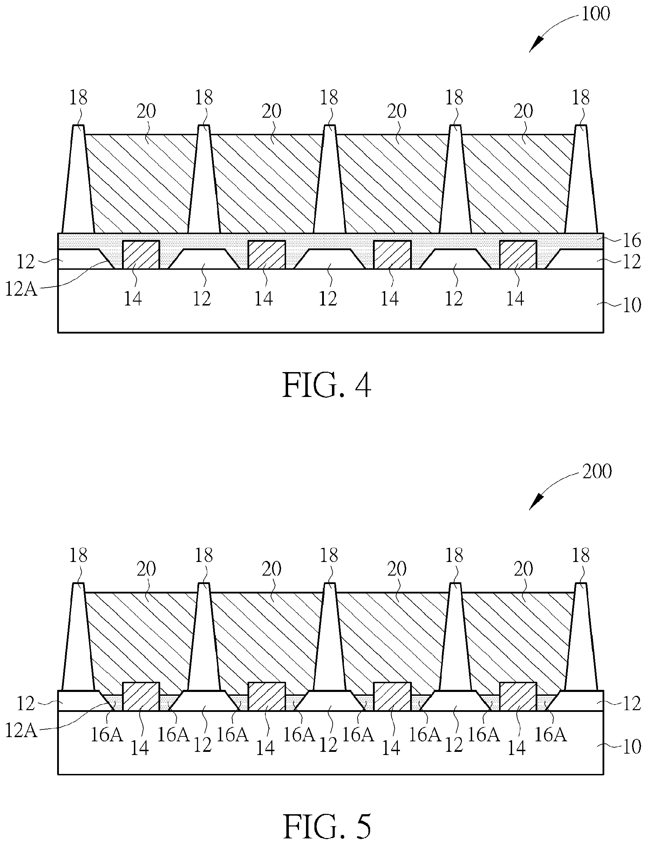

Next, as shown in Fig. 4, another insulating layer 20 is formed on the insulating layer 16 to complete the light emitting device 100 of this embodiment, the material of the insulating layer 20 may be the same as that of the insulating layer 16, and may include transparent material or translucent material, such as PMMA, polycarbonate, silicone resin, epoxy resin or the combination thereof. The insulating layer 20 is formed between the collimators 18, which can fix the collimators 18 to improve the structural stability. In this embodiment, the top surface of the insulating layer 20 is slightly lower than the top surface of the collimator 18, that is, a part of the top surface of the collimator 18 is not covered by the insulating layer 20, but this disclosure is not limited to this.

Therefore, in the first embodiment described in the present disclosure, a method of combining a light emitting unit and a collimator of a light emitting device is provided. In the process of manufacturing light emitting devices, collimators are directly formed above the light emitting units and arranged corresponding to the light emitting units (the "corresponding" means that the light emitting units are located between two adjacent collimators, or collimators are arranged adjacent to both sides of the light emitting units). Therefore, a light emitting device including a collimator can be manufactured. Subsequently, the light emitting devices with light emitting units can be made into display devices, that is, display devices with anti-peeping function can be formed, and the thickness of the display devices formed by the method described in this disclosure can be reduced.

The following description will focus on different embodiments of the manufacturing method of the light emitting device disclosed in this disclosure, and in order to simplify the description, the following description will mainly focus on the differences of each embodiment, and will not repeat the similarities. In addition, the same elements in each embodiment of this disclosure are labeled with the same reference numerals, so as to facilitate the comparison among the embodiments.

In different embodiments of the present disclosure, the insulating layer 16 with different shapes can be formed by adjusting the process parameters. For example, as shown in Fig. 5, which shows a schematic cross-sectional structure of the light emitting unit according to the second embodiment of this disclosure, the insulating layer 16A of the light emitting device 200 in this embodiment is similar in material and function to the insulating layer 16 described in the first embodiment, but the insulating layer 16A does not completely cover the light emitting unit 14, but encloses or surrounds the lower part of the light emitting unit 14, while the upper part of the light emitting unit 14 is exposed (subsequently covered by the insulating layer 20). In this embodiment, the collimator 18 can be formed on the pixel definition layer 12. Other elements are the same as those in the first embodiment, and will not be described in detail here.

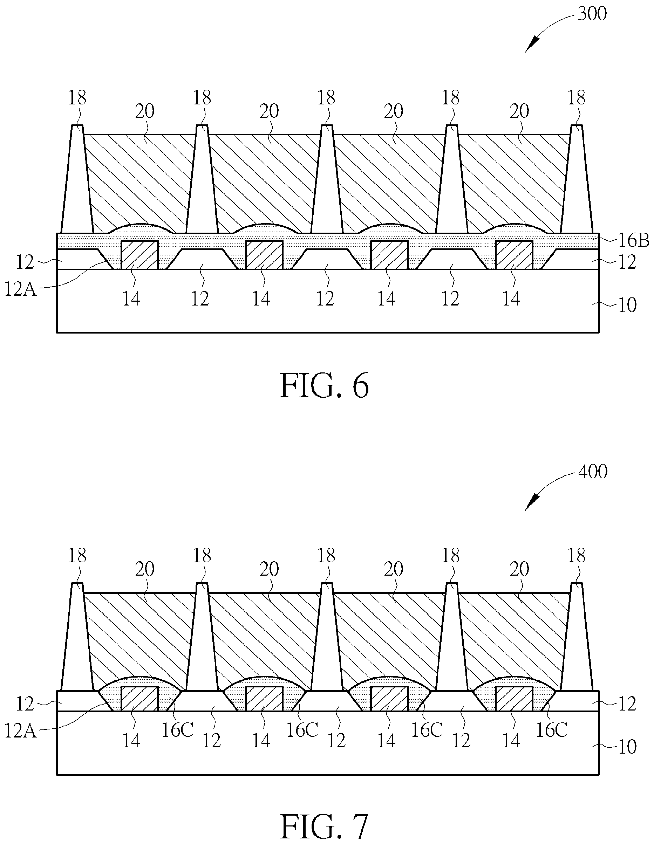

In other embodiments of this disclosure, as shown in Fig. 6, which shows a schematic cross-sectional structure of a light emitting unit according to a third embodiment of this disclosure, the insulating layer 16B of the light emitting device 300 in this embodiment is similar in material and function to the insulating layer 16 described in the first embodiment, but the insulating layer 16B covers the light emitting unit 14 and the pixel definition layer 12 and forms a corresponding convex surface above the light emitting unit 14. The insulating layer 16B having a convex surface can provide a light condensing function. The structure described in this embodiment also falls within the scope of this disclosure. Other elements are the same as those in the first embodiment, and will not be described in detail here.

In other embodiments of this disclosure, as shown in Fig. 7, Fig. 7 shows a schematic cross-sectional structure of a light emitting unit according to a fourth embodiment of this disclosure. the material and function of the insulating layer 16C of the light emitting device 400 in this embodiment are similar to those of the insulating layer 16 described in the first embodiment, but the insulating layer 16C covers the light emitting unit 14 and forms a corresponding convex surface above the light emitting unit 14. Besides, in this embodiment, the insulating layer 16C is not a whole layer structure, but is divided into a plurality of insulating layers 16C by the pixel defining layer 12. It can be regarded that the insulating layer 16C is formed in the opening 12A of the pixel defining layer 12 without covering the top surface of the pixel defining layer 12. The structure described in this embodiment also falls within the scope of this disclosure. Other elements are the same as those in the first embodiment, and will not be described in detail here.

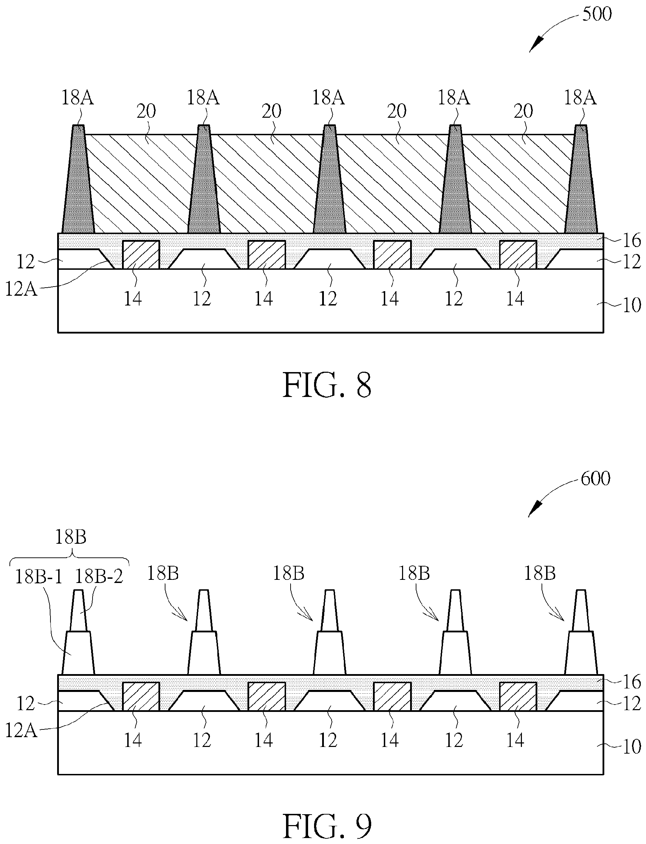

In other embodiments of the present disclosure, as shown in Fig. 8, Fig. 8 shows a schematic cross-sectional structure of a light emitting unit according to a fifth embodiment of the present disclosure. In this embodiment, the collimator 18A of the light emitting device 500 has a different color from the collimator 18 described in the first embodiment, such as black, white or gray. The color or material of the collimator is not limited in this disclosure. The structure described in this embodiment also falls within the scope of this disclosure. Other elements are the same as those in the first embodiment, and will not be described in detail here.

In other embodiments of the present disclosure, as shown in Fig. 9, Fig. 9 shows a schematic cross-sectional structure of a light emitting unit according to a sixth embodiment of the present disclosure. In this embodiment, the collimator of the light emitting device 600 can be made into different shapes. For example, the collimator 18B is formed into a lower part 18B-1 and an upper part 18B-2 respectively by two photolithography processes, the upper part 18B-2 is located above the lower part 18B-1. In some cases, the height-width ratio of the collimator 18 is large (that is, the value of height divided by width is large), which is difficult to manufacture and the structure is easy to collapse. Therefore, in this embodiment, the collimator 18B is divided into upper part and lower part and manufactured in different steps, which can reduce the manufacturing difficulty and the probability of structural collapse. Other elements are the same as those in the first embodiment, and will not be described in detail here.

In addition to the above-mentioned formation of collimators by photolithography process, collimators can be formed by other methods in this disclosure, such as printing process, inkjet process, imprint process, screen printing process, etc., all of which may form collimators described in this disclosure. As these processes are well-known technologies in the field, they will not be described in detail here.

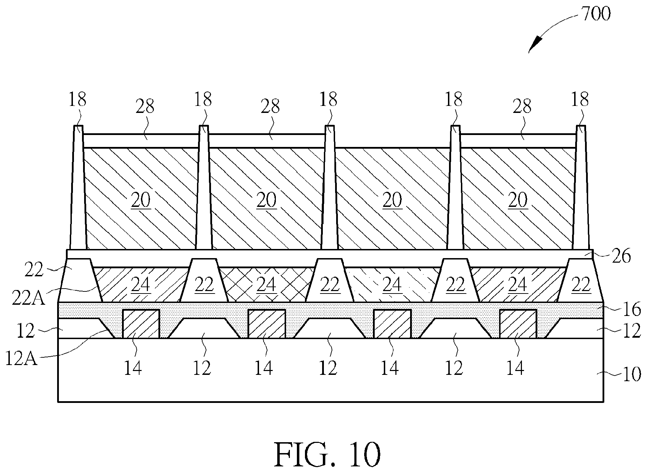

In other embodiments of this disclosure, other kinds of light emitting units and collimators can be combined to make light emitting devices. Please refer to Fig. 10, which shows a schematic cross-sectional structure of a light emitting unit according to a seventh embodiment of the present disclosure. In this embodiment, a quantum dot light emitting diode (QD LED) is taken as an example, and a collimator is bonded to manufacture a light emitting device 700. As shown in Fig. 10, this embodiment is different from the first embodiment in that a second pixel defining layer 22 and a plurality of color conversion units 24 are formed above the insulating layer 16 after the insulating layer 16 is completed and before the collimator 18 is formed, wherein the second pixel defining layer 22 has an opening 22A, and the position of the opening 22A of the second pixel defining layer 22 can correspond to the opening 12A of the pixel defining layer 12, and each color conversion unit 24 is respectively arranged in one opening 22A and corresponds to each other. That is, the position of the second pixel definition layer 22 is aligned with the pixel definition layer 12 in the vertical direction, but is not limited to. The positions of the color conversion units 24 are also aligned with the light emitting units 14 in the vertical direction, but are not limited to this. The "aligned with" mentioned above means that the light emitted by the light emitting unit 14 passes through the corresponding color conversion unit 24. Therefore, the light emitted from the light emitting unit 14 will sequentially pass through the insulating layer 16 and the color conversion unit 24. Then, a relatively flat second insulating layer 26 is formed on the second pixel definition layer 22 and the color conversion unit 24, and then the collimator 18 and the insulating layer 20 mentioned in the previous embodiments are formed in sequence. In addition, an additional filter layer 28 can be formed on a top surface of the insulating layer 20, or in some other embodiments, a filter layer may be used to replace part of the insulating layer 20 (not shown), that is to say, the filter layer 28 is directly formed instead of the insulating layer 20 above the second insulating layer 26, which is also within the scope of this disclosure. But the present disclosure is not limited thereto.

In this embodiment, the color conversion unit 24 may include quantum dots, phosphor materials, fluorescence materials, pigments, dyes, scattering particles or filter layers, but is not limited thereto. The quantum dots can be composed of semiconductor nanocrystalline structures, such as CdSe, CdS, CdTe, ZnSe, ZnTe, ZnS, HgTe, InAs, Cd1-xZnxSe1-ySy, CdSe/ZnS, InP and GaAs, but are not limited thereto. The main function of the color conversion unit 24 is to convert light of a specific color (e.g., blue light) into light of other colors (e.g., green light or red light). If the light emitting unit 14 in this embodiment is, for example, a blue light emitting diode, the light emitting device 100 can emit light of red, blue, green and other colors by cooperating with the color conversion unit 24 to convert blue light into light of other colors. The material of the second insulating layer 26 may be the same as or different from that of the insulating layer 16, for example, acrylic (PMMA), polycarbonate, silicone resin, epoxy resin or their mixture, but this disclosure is not limited thereto. The second insulating layer 26 can also achieve the functions of planarizing and protecting the underlying elements. The filter layer 28 is, for example, a blue light filter layer for filtering blue light that is not completely converted, but this disclosure is not limited to this. The filter layer 28 may also filter light of other colors, or in other embodiments, the filter layer 28 may be omitted, and all these structures are within the scope of this disclosure. In this embodiment, the quantum dot light emitting diode is bonded with the collimator, and other details about the quantum dot light emitting diode belong to the well-known technology in the field, and will not be described in detail here.

To sum up, the present disclosure is characterized by providing a method for directly combining a light emitting unit with a collimator in the process of manufacturing a light emitting device. In this way, the light emitting device in the subsequent display device itself has a collimator, so that the user can see the displayed screen only when viewing the display device from a specific angle, that is to say, the display device itself has an anti-peeping function. In the traditional technology, sticking the peep-proof film on the surface of the finished display device may have some problems, such as uneven adhesion, thick thickness, poor light transmittance and so on. According to the present disclosure, the above problems can be overcome, and a display device with higher quality and peep prevention function can be manufactured.

For those skilled in the art, the technical features disclosed in the aforementioned embodiments can be replaced or recombined with one another to constitute another embodiment without departing from the spirit of the present disclosure.

## Claims

1. A method of manufacturing a light emitting device (100), **characterized by**:
providing a substrate (10);
bonding a light emitting unit (14) on the substrate (10);
forming an insulating layer (16) on the substrate so that at least a part of the light emitting unit (14) is enclosed by the insulating layer (16); and
forming a collimator (18) corresponding to the light emitting unit (14) on the substrate (10) after the insulating layer (16) is formed.

2. The method according to claim 1, **characterized in that** the insulating layer (16) is formed by a printing process.

3. The method according to claim 1, **characterized in that** the collimator (18) is formed by a photolithography process.

4. The method according to claim 1, **characterized in that** the collimator (18) is formed by an imprinting process.

5. The method according to claim 1, **characterized in that** the collimator (18) is formed by a screen printing process.

6. The method according to claim 1, **characterized by** further comprising:
forming a color conversion unit (24) corresponding to the light emitting unit (14) after the insulating layer (16) is formed.
